# EUROPEAN PATENT SPECIFICATION

(11) **EP 3 790 368 B1**
(45) Date of publication and mention of the grant of the patent: **02.08.2023**
(21) Application number: 18917110.1
(22) Date of filing: 02.05.2018
(51) Int. Cl.: H05K 13/04, B23Q 11/00, F16F 15/02, F16F 7/108

(54) **USE METHOD OF WORK MACHINE**
VERWENDUNGSVERFAHREN EINER ARBEITSMASCHINE
PROCÉDÉ D'UTILISATION D'UNE MACHINE DE TRAVAIL

(43) Date of publication of application: 10.03.2021
(73) Proprietor: Fuji Corporation, Chiryu-shi, Aichi 472-8686 (JP)
(72) Inventor: SAKURAYAMA,Takeshi, Chiryu-shi, Aichi 472-8686 (JP); YAMADA, Kazunori, Chiryu-shi, Aichi 472-8686 (JP)
(74) Representative: Grünecker Patent- und Rechtsanwälte PartG mbB
(86) International application number: PCT/JP2018/017546
(87) International publication number: WO 2019/211911

(56) References cited:
- EP-A1- 0 697 808
- WO-A1-02/066949
- JP-A- 2004 306 206
- JP-A- 2007 027 533
- JP-A- 2010 173 026
- JP-A- 2015 082 059

## Description

### Technical Field

A technique disclosed in the present description relates to a work machine and a method for using the work machine.

### Background Art

The document JP-A-2007-27533 discloses a component mounting device for mounting components on a board. The component mounting device of JP-A-2007-27533 includes an operation section configured to operate when a component is mounted on a board. The component mounting device vibrates when the operation section operates. In addition, the component mounting device of JP-A-2007-27533 includes a dynamic vibration absorber attached thereto to suppress vibration.

The document JP2015082059A discloses means for guiding a user in placing a vibration damper when installing office equipment such as a printer.

### Summary of the Invention

### Technical Problem:

In the case that a dynamic vibration absorber is attached to a component mounting device, a vibrating state occurring when an operation section of the component mounting device operates differs depending upon an attachment position of the dynamic vibration absorber or a type of a dynamic vibration absorber to be attached. The attachment position of the dynamic vibration absorber or the type of the dynamic vibration absorber so attached may suppress the vibration of the component mounting device sufficiently in one case and may not suppress the vibration of the component mounting device so sufficiently in another case. Even though the dynamic vibration absorber is attached to the component mounting device, there may be a possibility that there is caused a problem in mounting a component on a board unless the vibration of the component mounting device is suppressed. Then, the present description provides a technique for letting a user know of information relating to a dynamic vibration absorber configured to suppress vibration. [Solution to Problem]

The present invention provides a method for using a work machine in accordance with claim 1. A work machine disclosed by the present description, which is not covered by the claimed invention, includes an operation section, a display section, a memory section, and a control section. Positional information indicating an attachment position of at least one dynamic vibration absorber and/or type information indicating a type of at least one dynamic vibration absorber is stored in the memory section, those information of which being obtained in a case that an amplitude in a specific position on the work machine becomes equal to or smaller than a predetermined threshold amplitude when the work machine vibrates as a result of the operation section operating with the at least one dynamic vibration absorber attached to the work machine. The control section displays the positional information and/or the type information, which is stored in the memory section, on the display section.

With this configuration, the positional information and/or the type information of the dynamic vibration absorber, information of which being obtained when the amplitude in the specific position on the work machine becomes the threshold amplitude or smaller, is displayed on the display section, so that the user can be noticed of the information on the dynamic vibration absorber for suppressing the vibration of the work machine.

### [Brief Description of Drawings]

[Fig. 1] Fig. 1 is a drawing showing a schematic configuration of a component mounting device
[Fig. 2] Fig. 2 is a flowchart showing a first process of a method for using the component mounting device
[Fig. 3] Fig. 3 is a drawing for explaining a method for measuring an amplitude in the position of a distal end portion of a suction nozzle.
[Fig. 4] Fig. 4 is a drawing showing an example of an amplitude in the position of the distal end portion of the suction nozzle without a dynamic vibration absorber.
[Fig. 5] Fig. 5 is a drawing showing an example of an amplitude in the position of the distal end portion of the suction nozzle with a dynamic vibration absorber.
[Fig. 6] Fig. 6 is a flowchart showing a second process of the method for using the component mounting device
[Fig. 7] Fig. 7 is a drawing showing an example of a display on a display section.
[Fig. 8] Fig. 8 is a perspective view showing a damper as a dynamic vibration absorber with a part thereof disassembled.

### Description of Embodiments

A work machine will be described. A work machine is a component mounting device, which is a machine for performing component mounting work. The component mounting device is a device for mounting multiple electronic components on a circuit board. The component mounting device is also referred to as a surface mounting device or a chip mounter. Normally, the component mounting device is disposed together with a solder printing device, other component mounting devices, and a board inspection device to form a mounting line.

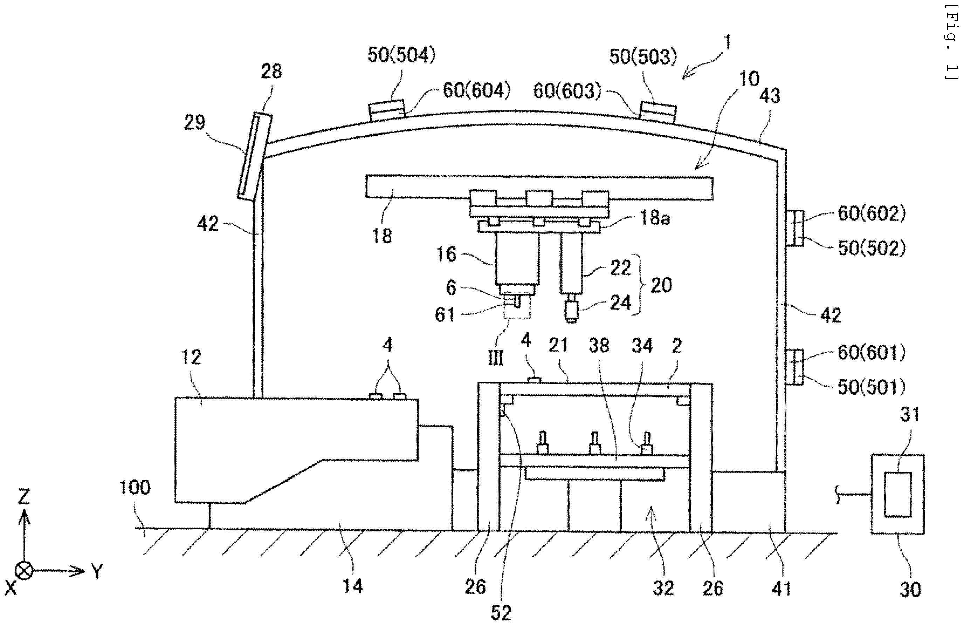

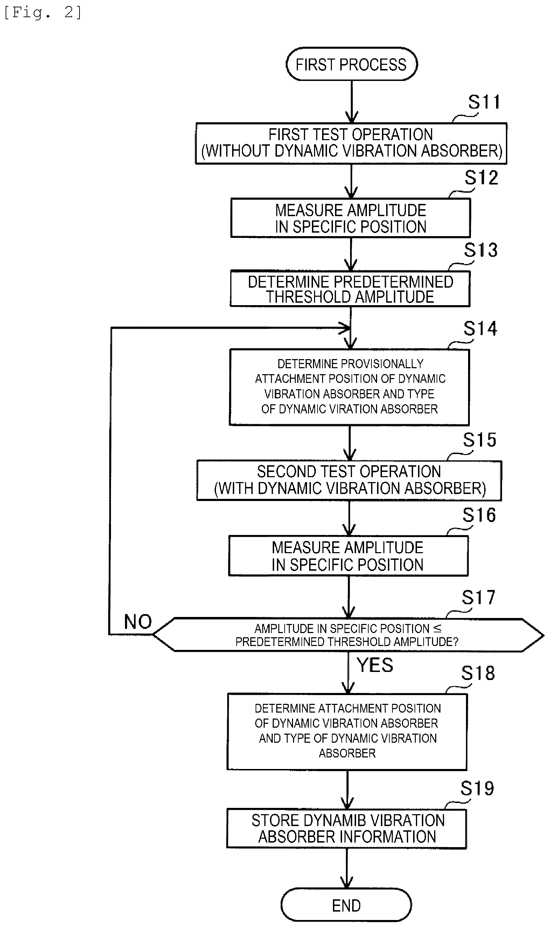

As shown in Fig. 1, component mounting device 1 includes operation section 10 and control section 30. Operation section 10 includes multiple component feeders 12 (single component feeder 12 is shown as representing them in Fig. 2), feeder holding section 14, mounting head 16, imaging unit 20, moving mechanism 18 for moving mounting head 16 and imaging unit 20, and conveyance device 26. Additionally, component mounting device 1 includes device table 41, support section 42, hood 43, and operation panel 28.

Component mounting device 1 is installed on floor 100 of a factory or the like. For example, component mounting device 1 is installed on a floor of a factory where component mounting device 1 is manufactured. In addition, there may be a case in which component mounting device 1 is manufactured in a factory, shipped from the factory, and is thereafter installed on a floor of another factory to which component mounting machine so shipped is destined.

Each component feeder 12 of component mounting device 1 installs therein multiple electronic components 4. Each component feeder 12 is a device for supplying multiple electronic components 4 to be mounted on circuit board 2. Each component feeder 12 is detachably attached to feeder holding section 14 to supply electronic components 4 to mounting head 16. Each component feeder 12 is, for example, a tape-type feeder for accommodating multiple electronic components 4 in the form of a wound tape. Each component feeder 12 can supply electronic components 4 by feeding a tape in which multiple electronic components 4 are arranged to be aligned lengthwise. Each component feeder 12 may be either a tray-type feeder for accommodating multiple electronic components 4 on a tray or a bulk-type feeder for accommodating randomly multiple electronic components 4 in a container. The specific configuration of component feeder 12 is not particularly limited.

Moving mechanism 18 moves mounting head 16 and imaging unit 20 between component feeder 12 and circuit board 2. Moving mechanism 18 is an XY robot for moving movement base 18a in an X- and Y-directions. Moving mechanism 18 is made up of a guide rail for guiding movement base 18a, a moving mechanism for moving movement base 18a along the guide rail, a motor for driving the moving mechanism, and the like. Moving mechanism 18 is disposed above component feeder 12 and circuit board 2. Mounting head 16 and imaging unit 20 are attached to movement base 18a. Mounting head 16 and imaging unit 20 are moved above component feeder 12 and above circuit board 2 by moving mechanism 18.

Mounting head 16 includes suction nozzle 6 for picking up electronic component 4. Tip 62 (not shown in Fig. 1), which will be described later, is attached to distal end portion 61 of suction nozzle 6. Suction nozzle 6 is detachable from mounting head 16. Suction nozzle 6 is attached to mounting head 16 in such a manner as to move in a Z-direction (in an up-down direction in the drawing). Suction nozzle 6 can be raised and lowered in the up-down direction by an actuator (not shown) installed in mounting head 16 and can pick up an electronic component 4. To mount electronic component 4 on circuit board 2 with mounting head 16, moving mechanism 18 first moves mounting head 16 to a component pickup position. Next, suction nozzle 6 is moved downwards until distal end portion 61 of suction nozzle 6 is brought into abutment with electronic component 4 accommodated in component feeder 12. Next, electronic component 4 is picked up by suction nozzle 6, and suction nozzle 6 is moved upward. Mounting head 16 is then moved to a component mounting position by moving mechanism 18 and is positioned with respect to circuit board 2. Then, by lowering suction nozzle 6 toward circuit board 2, electronic component 4 is mounted on circuit board 2.

Imaging unit 20 is attached to movement base 18a. This allows imaging unit 20 to move together when mounting head 16 moves. Imaging unit 20 includes camera support 22 and camera 24. Camera support 22 is attached to movement base 18a. Camera 24 is attached to camera support 22.

Camera 24 is a device for imaging surface 21 of circuit board 2. Camera 24 comes to be disposed above circuit board 2 when imaging unit 20 is moved to a position above circuit board 2 (in the Z-direction in the drawing) by moving mechanism 18. Camera 24 images surface 21 of circuit board 2 with a whole of surface 21 of circuit board 2 put in an imaging range of camera 24 from above circuit board 2. Image data of surface 21 of circuit board 2, which is captured by camera 24, is transmitted to control section 30. Camera 24 includes a camera control section (not shown) for controlling the operation of camera 24. The operation of camera 24 is controlled by the camera control section.

Conveyance device 26 is a device for conveying in circuit board 2 into component mounting device 1, conveying and positioning circuit board 2 to the component mounting position, and conveying out circuit board 2 from component mounting device 1. Conveyance device 26 can be made up of, for example, a pair of belt conveyors, supporting device 32 attached to the belt conveyor so as to support circuit board 2 from below, and a driving device for driving the belt conveyors. Circuit board 2 is conveyed in the X-direction of the drawing.

Supporting device 32 includes support table 38 and multiple support pins 34. Support table 38 and multiple support pins 34 are disposed below circuit board 2. Support table 38 can be raised and lowered vertically. Multiple support pins 34 are fixed to support table 38 and project upwards. In supporting device 32 described above, when circuit board 2 is conveyed to a predetermined work position by the belt conveyors, support table 38, which is disposed below circuit board 2, rises. As a result of support table 38 rising, multiple support pins 34 fixed to support table 38 lift circuit board 2 upward.

Device table 41 of component mounting device 1 is placed on floor 100 of a factory or the like. Feeder holding section 14 and conveyance device 26 are fixed to device table 41. Support section 42 is fixed to device table 41. Support section 42 is disposed between device table 41 and hood 43. Support section 42 supports hood 43. Support section 42 has a columnar shape. Hood 43 covers operation section 10.

Support section 42 includes multiple attachment portions 60 (601, 602). Hood 43 includes multiple attachment portions 60 (603, 604). Dynamic vibration absorber 50 (501, 502, 503, 504) is attached to each attachment portion 60 (601, 602, 603, 604). Each attachment portion 60 includes a holder (not shown) made of metal, for example, and can hold corresponding dynamic vibration absorber 50.

Each dynamic vibration absorber 50 is, for example, a cylindrical weight. Multiple types of dynamic vibration absorbers 50 are adopted. For example, there are adopted four types of dynamic vibration absorbers 501, 502, 503, and 504 of 100g, 200g, 300g, and 400g, respectively. Each dynamic vibration absorber 50 can be attached to corresponding attachment portion 60 with screws or the like, for example. The configuration of each dynamic vibration absorber 50 is not limited particularly.

As to operation panel 28 of component mounting device 1, operation panel 28 is fixed to support section 42. Operation panel 28 is an input device for receiving instructions from an operator. Operation panel 28 includes liquid crystal display section 29. Liquid crystal display section 29 displays various types of information thereon. For example, liquid crystal display section 29 displays thereon information on dynamic vibration absorbers 50 which are attached to component mounting device 1.

Control section 30 of component mounting device 1 includes a computer including CPU (not shown) and memory 31 (an example of a memory section). Although not shown, component feeders 12, mounting head 16, moving mechanism 18, and operation panel 28 are communicably connected to control section 30. Control section 30 controls the mounting of electronic components 4 on circuit boards 2 by controlling each of the sections (12, 16, 18, 28, 32, etc.). Additionally, memory 31 stores various types of information. For example, memory 31 stores information on dynamic vibration absorbers 50 which are attached to component mounting device 1.

In component mounting device 1 described above, component mounting device 1 may vibrate as a result of the operation of moving mechanism 18, mounting head 16, and the like when mounting multiple electronic components 4 on circuit boards 2. At this time, with the configuration described above, there may be a case in which the vibration of component mounting device 1 is suppressed by dynamic vibration absorbers 50. The vibration of device table 41 is suppressed by dynamic vibration absorbers 50 when operation section 10 operates.

Next, there will be described a method for using component mounting device 1 described above. Firstly, a first process of the method for using component mounting device 1 will be described. The first process is executed when component mounting device 1 is placed in a factory where it is manufactured.

As shown in Fig. 2, in step S11 of the first process, a first test operation is executed on component mounting device 1. In the first test operation, operation section 10 of component mounting device 1 is caused to operate. For example, movement base 18a of component mounting device 1 is caused to operate in the X-direction and Y-direction. Additionally, mounting head 16 and suction nozzle 6 of component mounting device 1 are caused to operate in the Z-direction. The first test operation in step S11 is executed without any dynamic vibration absorber 50. Consequently, in the first test operation, operation section 10 operates without any dynamic vibration absorber 50 attached to attachment portions 60 of component mounting device 1. Component mounting device 1 vibrates as a result of operation section 10 operating. Therefore, suction nozzle 6 of component mounting device 1 vibrates, for example, in the Y-direction.

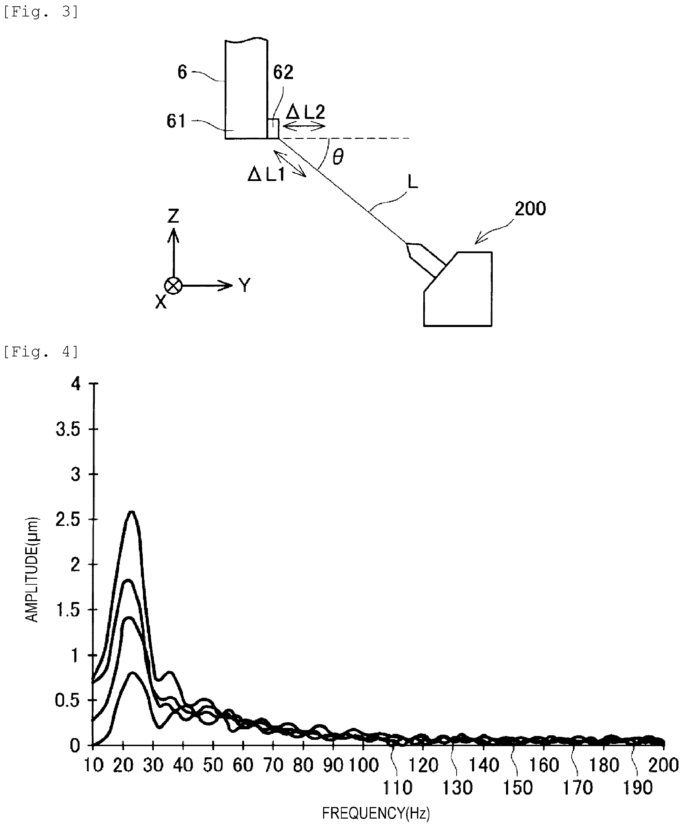

Subsequently, in S12, an amplitude in the position of distal end portion 61 of suction nozzle 6 (an example of a specific position) is measured. In the present embodiment, an amplitude in the position of distal end portion 61 of suction nozzle 6 in the Y-direction is measured. In S 12, an amplitude is measured with no electronic component 4 picked up by suction nozzle 6. Here, a method for measuring an amplitude in the position of distal end portion 61 of suction nozzle 6 will be described. As shown in Fig. 3, an amplitude in the position of distal end portion 61 of suction nozzle 6 is measured with laser displacement meter 200. Laser displacement meter 200 is a device for measuring a displacement amount when the position of a measuring target is displaced.

In component mounting device 1 described above, ceramic tip 62 is attached to distal end portion 61 of suction nozzle 6. When measuring an amplitude in the position of distal end portion 61 of suction nozzle 6, laser displacement meter 200 irradiates laser L to tip 62 attached to distal end portion 61 of suction nozzle 6. An angle formed by an irradiating direction of laser L and the Y-direction is assumed to be θ. Laser L irradiated from laser displacement meter 200 strikes tip 62 attached to distal end portion 61 of suction nozzle 6 and is then reflected. Laser L reflected by tip 62 travels toward laser displacement meter 200 and enters laser displacement meter 200. Laser displacement meter 200 calculates displacement amount ΔL1 of the position of distal end portion 61 of suction nozzle 6 in the irradiating direction of laser L based on laser L that has entered laser displacement meter 200. Additionally, laser displacement meter 200 calculates displacement amount ΔL2 of the position of distal end portion 61 of suction nozzle 6 in the Y-direction based on displacement amount ΔL1. Specifically speaking, ΔL2=ΔL1×cosθ. Displacement amount ΔL2 that laser displacement meter 200 calculates corresponds to an amplitude in the position of distal end portion 61 of suction nozzle 6 in the Y-direction.

As shown in Fig. 4, an amplitude in the position of distal end portion 61 of suction nozzle 6 is measured in accordance with, for example, a frequency component in vibration of suction nozzle 6. For example, an amplitude of a frequency component of 25Hz is 2.5µm.

As shown in Fig. 2, subsequently, in S13 of the first process, a predetermined threshold amplitude is determined based on the amplitude measured in S12 as described above. For example, a value of 50% of a maximum value of the amplitude measured in S12 is set as a predetermined threshold amplitude. The predetermined threshold amplitude is not particularly limited.

Subsequently, in S14, attachment positions for multiple dynamic vibration absorbers 50 are determined provisionally. Additionally, types of dynamic vibration absorbers 50 corresponding to the provisionally determined attachment positions are determined provisionally. That is, which dynamic vibration absorber 50 is attached to which attachment portion 60 on component mounting device 1 is determined provisionally. Combinations of multiple attachment portions 60 and multiple dynamic vibration absorbers 50 are determined provisionally. For example, it is provisionally determined that as shown in Fig. 1, dynamic vibration absorber 501 (100g) is attached to attachment portion 601, dynamic vibration absorber 502 (200g) is attached to attachment portion 602, dynamic vibration absorber 503 (300g) is attached to attachment portion 603, and dynamic vibration absorber 504 (400g) is attached to attachment portion 604. Then, the provisionally determined types of dynamic vibration absorbers 50 are individually attached to the provisionally determined attachment positions.

Subsequently, in S15, a second test operation is executed on component mounting device 1. In the second test operation, as with the first test operation described above (S11), operation section 10 of component mounting device 1 is caused to operate. For example, movement base 18a of component mounting device 1 is caused to operate in the X-direction and Y-direction. Additionally, mounting head 16 and suction nozzle 6 of component mounting device 1 are caused to operate in the Z-direction. The second test operation in S15 is executed with dynamic vibration absorbers 50. Consequently, in the second test operation, operation section 10 operates with dynamic vibration absorbers 50 in a state of being attached individually to corresponding attachment portions 60 on component mounting device 1. Component mounting device 1 vibrates as a result of operation section 10 operating. Therefore, suction nozzle 6 of component mounting device 1 vibrates, for example, in the Y-direction.

Subsequently, in S16, an amplitude in the position of distal end portion 61 of suction nozzle 6 is measured as done in S12. In the present embodiment, an amplitude in the position of distal end portion 61 of suction nozzle 6 in the Y-direction is measured. In S 16, an amplitude is measured with no electronic component 4 piked up by suction nozzle 6. An amplitude in the position of distal end portion 61 of suction nozzle 6 is measured by laser displacement meter 200. Since a method for measuring an amplitude in the position of distal end portion 61 of suction nozzle 6 is similar to that used in S12 described above, a detailed description thereof will be omitted here.

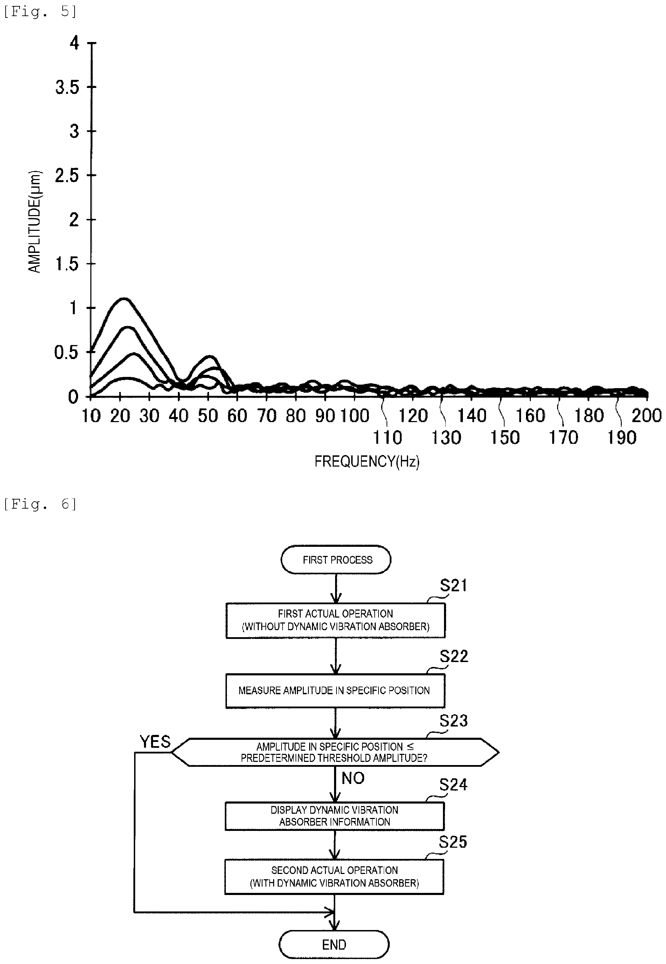

As shown in Fig. 5, the amplitude becomes smaller with dynamic vibration absorbers 50 (S15) than without dynamic vibration absorbers 50 (S11, refer to Fig. 4). An amplitude in the position of distal end portion 61 of suction nozzle 6 is measured in accordance with, for example, a frequency component in the vibration of suction nozzle 6. For example, an amplitude of a frequency component of 25Hz is 1.2µm.

As shown in Fig. 2, subsequently, in S17 of the first process, it is determined whether the amplitude in the position of distal end portion 61 of suction nozzle 6 measured in S16 described above is equal to or smaller than the predetermined threshold amplitude determined in S13 described above. If the amplitude measured in S16 is equal to or smaller than the threshold amplitude determined in S13 (YES in S17), the process proceeds to S18. If it is determined otherwise (NO in S17), the process returns to S14 described above.

In S14 after it is determined otherwise in S17 or as NO in S17, attachment positions where to attach multiple dynamic vibration absorbers 50 are determined provisionally again. Additionally, types of dynamic vibration absorbers 50 corresponding to the provisionally determined attachment positions are determined provisionally again. That is, as for which dynamic vibration absorber 50 is attached to which attachment portion 60 of component mounting device 1, this is determined provisionally again. Combinations of multiple attachment portions 60 and multiple dynamic vibration absorbers 50 are determined provisionally again. In S14 after it is determined otherwise in S17 or as NO in S17, combinations are determined provisionally which differ from the combinations determined provisionally in S14 described above. For example, it is provisionally determined that dynamic vibration absorber 504 (400g) is attached to attachment portion 601,dynamic vibration absorber 503 (300g) is attached to attachment portion 602, dynamic vibration absorber 502 (200g) is attached to attachment portion 603, and dynamic vibration absorber 501 (100g) is attached to attachment portion 604. Then, the provisionally determined types of dynamic vibration absorbers 50 are individually attached to the provisionally determined attachment positions. Thereafter, the steps from S15 to S17 described above are executed again.

On the other hand, in S18 after it is determined positively or as YES in S17, attachment positions for multiple dynamic vibration absorbers 50 are determined. In S 18, the attachment positions, which are determined provisionally in S14 described above and which result when the positive determination is made in S17 or it is determined as YES in S17, are determined as attachment positions where to attach multiple dynamic vibration absorbers 50. Additionally, in S18, types of dynamic vibration absorbers 50 are determined which correspond individually to the determined attachment positions. In S18, the types of dynamic vibration absorbers 50, which are determined provisionally in S14 described above and which result when the positive determination is made in S17 or it is determined as YES in S17, are determined as types of dynamic vibration absorbers 50. For example, it is determined that in component mounting device 1, dynamic vibration absorber 501 (100g) is attached to attachment portion 601, dynamic vibration absorber 502 (200g) is attached to attachment portion 602, dynamic vibration absorber 503 (300g) is attached to attachment portion 603, and dynamic vibration absorber 504 (400g) is attached to attachment portion 604.

Subsequently, in S19, memory 31 is caused to store dynamic vibration absorber information relating to multiple dynamic vibration absorbers 50 determined in S18 described above. The dynamic vibration absorber information includes positional information indicating the attachment positions of multiple dynamic vibration absorbers 50 determined in S18 described above. In addition, the dynamic vibration absorber information include type information indicating the types of multiple dynamic vibration absorbers 50 determined in S18 described above. That is, the dynamic vibration absorber information includes information indicating which dynamic vibration absorber 50 is to be attached to which attachment portion 60. The dynamic vibration absorber information includes information indicating the combinations of multiple attachment portions 60 and multiple dynamic vibration absorbers 50. For example, the dynamic vibration absorber information includes information indicating that dynamic vibration absorber 501 (100g) is attached to attachment portion 601, dynamic vibration absorber 502 (200g) is attached to attachment portion 602, dynamic vibration absorber 503 (300g) is attached to attachment portion 603, and dynamic vibration absorber 504 (400g) is attached to attachment portion 604. The positional information and the type information which are included in the dynamic vibration absorber information are associated with each other. Thus, the first process is completed as described above.

There may be a case in which component mounting device 1 on which the first process is completed is shipped from, for example, the factory of the company where it is assembled to a factory of another company after the first process is so completed. Consequently, component mounting device 1 on which the first process is completed may be installed in the factory of the other factory after the first process is so completed.

Next, a second process of the method for using component mounting device 1 will be described. When the second process is executed, component mounting device 1 is installed in a different place from that where the first process is executed. The second process is executed, for example, when component mounting device 1 is installed in a factory of another company.

As shown in Fig. 6, in S21 of the second process, a first actual operation of component mounting device 1 is executed. In the first actual operation, similarly to the first test operation described above (S11), operation section 10 of component mounting device 1 is caused to operate. For example, movement base 18a of component mounting device 1 is caused to operate in the X-direction and Y-direction. Additionally, mounting head 16 and suction nozzle 6 of component mounting device 1 are caused to operate in the Z-direction. The first actual operation, which is executed in S21, is executed without dynamic vibration absorber 50. Consequently, in the first actual operation, operation section 10 operates with no dynamic vibration absorber 50 attached to corresponding attachment portion 60 of component mounting device 1. Component mounting device 1 vibrates as a result of operation section 10 operating. Therefore, suction nozzle 6 of component mounting device 1 vibrates, for example, in the Y-direction.

Subsequently, in S22, as in the case with S12 described above, an amplitude in the position of distal end portion 61 of suction nozzle 6 is measured. In the present embodiment, an amplitude in the position of distal end portion 61 of suction nozzle 6 in the Y-direction is measured. In S22, an amplitude is measured with no electronic component 4 picked up by suction nozzle 6. An amplitude in the position of distal end portion 61 of suction nozzle 6 is measured by laser displacement meter 200. Since a method for measuring an amplitude in the position of distal end portion 61 of suction nozzle 6 is similar to that used in S12 described above, a detailed description thereof will be omitted here.

Subsequently, in S23, it is determined whether the amplitude in the position of distal end portion 61 of suction nozzle 6 measured in S22 is equal to or smaller than the predetermined threshold amplitude determined in S13 described above. If the amplitude measured in S22 is equal to or smaller than the threshold amplitude determined in S13 (YES in S17), subsequent steps of S24 and S25 are skipped over, and the second process is ended. If it is determined otherwise (NO in S17), the second process proceeds to S24.

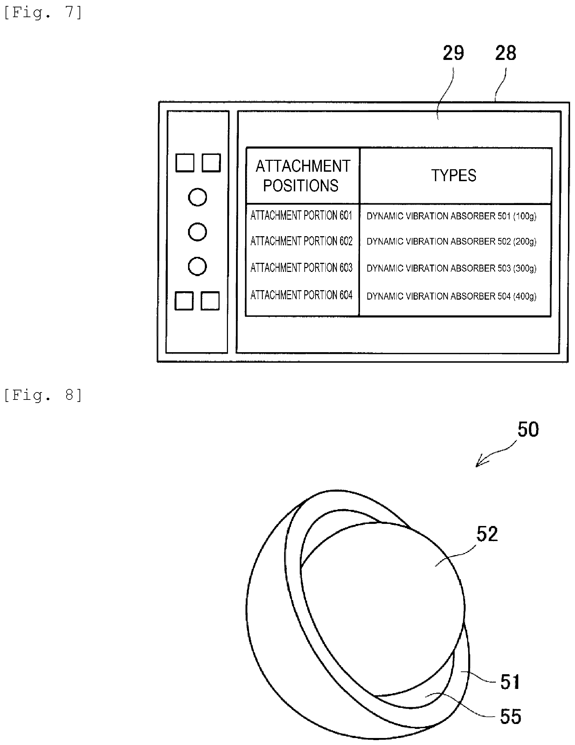

Subsequently, in S24, the dynamic vibration absorber information, which is stored in memory 31 in S19 of the first process as described above, is caused to be displayed on liquid crystal display section 29 of operation panel 28. In s24, control section 30 of component mounting device 1 causes the dynamic vibration absorber information stored in memory 31 to be displayed on liquid crystal display section 29. As shown in Fig. 7, control section 30 displays the positional information and the type information, which are included in the dynamic vibration absorber information, on liquid crystal display section 29. Control section 30 displays the positional information and the type information on liquid crystal display section 29 while associating them each other. That is, control section 30 displays information, indicating which dynamic vibration absorber 50 is to be attached to which attachment portion 60, on liquid crystal display section 29. Control section 30 displays information, indicating the combinations of multiple attachment portions 60 and multiple dynamic vibration absorbers 50, on liquid crystal display section 29. For example, control section 30 causes information to be displayed on liquid crystal display section 29, the information indicating that dynamic vibration absorber 501 (100g) is attached to attachment portion 601, dynamic vibration absorber 502 (200g) is attached to attachment portion 602, dynamic vibration absorber 503 (300g) is attached to attachment portion 603, and dynamic vibration absorber 504 (400g) is attached to attachment portion 604.

Subsequently, in S25, dynamic vibration absorbers 50, which are of the types described above, are attached to the corresponding attachment positions which are displayed on liquid crystal display section 29 in S24. Then, a second actual operation is executed on component mounting device 1. In the second actual operation, as in the case with the first actual operation (S21), operation section 10 of component mounting device 1 is caused to operate. For example, movement base 18a of component mounting device 1 is caused to operate in the X-direction and Y-direction. Additionally, mounting head 16 and suction nozzle 6 of component mounting device 1 are caused to operate in the Z-direction. The second actual operation is executed in S15 with dynamic vibration absorbers 50 attached to the corresponding attachment sections. Consequently, in the second actual operation, operation section 10 operates with individual dynamic vibration absorbers 50 attached to corresponding attachment portions 60 on component mounting device 1. Component mounting device 1 vibrates as a result of operation section 10 operating. Therefore, suction nozzle 6 of component mounting device 1 vibrates, for example, in the Y-direction.

In the second actual operation (S25), an amplitude in the position of distal end portion 61 of suction nozzle 6 becomes smaller than the amplitude measured during the first actual operation (S21). The amplitude measured with dynamic vibration absorbers 50 so attached (S25) becomes smaller than the amplitude measured with no dynamic vibration absorber 50 attached (S21).

As is apparent from the description made above, component mounting device 1 includes operation section 10, liquid crystal display section 29, memory 31, and control section 30. Memory 31 stores the dynamic vibration absorber information, which is obtained in a case that amplitude in the position of distal end portion 61 of suction nozzle 6 becomes equal to or smaller than the predetermined threshold amplitude when component mounting device 1 vibrates as a result of operation section 10 operating with multiple dynamic vibration absorbers 50 attached to component mounting device 1 (S17 to S19). The dynamic vibration absorber information includes the positional information indicating the attachment positions of multiple dynamic vibration absorbers 50 and the type information indicating the types of multiple dynamic vibration absorbers 50. Control section 30 causes the positional information and the type information, which are stored in memory 31, to be displayed on liquid crystal display section 29 (S24).

With this configuration, the dynamic vibration absorber information, information of which being obtained when amplitude in the position of distal end portion 61 of suction nozzle 6 becomes equal to or smaller than the predetermined threshold amplitude, is displayed on liquid crystal display section 29 of operation panel 28, so that the user can be noticed of the information for suppressing the vibration of component mounting device 1 (the positional information and the type information of multiple dynamic vibration absorbers 50. Then, the user can attach multiple dynamic vibration absorbers 50 to component mounting device 1 based on the dynamic vibration absorber information to thereby suppress the vibration of component mounting device 1.

While one embodiment has been described above, specific embodiments are not limited to the above embodiment. In the embodiment described above, while multiple dynamic vibration absorbers 50 are attached to component mounting device 1, the number of dynamic vibration absorbers 50 is not limited thereto. A configuration may be adopted in which one dynamic vibration absorber 50 is attached to component mounting device 1. At least one dynamic vibration absorber 50 is attached to component mounting device 1.

In the embodiment described above, while dynamic vibration absorbers 50 are attached to all attachment portions 60 on component mounting device 1, the configuration is not limited thereto. In another embodiment, a configuration may be adopted in which one or some dynamic vibration absorbers 50 are attached to one or some attachment portions 60 in multiple attachment portions 60 on component mounting device 1. Additionally, in the embodiment described above, while component mounting device 1 is configured to include multiple attachment portions 60, the configuration is limited thereto. For example, the number of attachment portions 60 may be one.

In the embodiment described above, while the positional information and the type information are included in the dynamic vibration absorber information stored in memory 31, the configuration is not limited thereto. A configuration may be adopted in which only either of the positional information and the type information is included in the dynamic vibration absorber information. That is, a configuration may be adopted in which memory 31 stores either the positional information or the type information of dynamic vibration absorber 50. In addition, a configuration may be adopted in which either the positional information or the type information of dynamic vibration absorbers 50 is displayed on liquid crystal display section 29.

In the embodiment described above, while an amplitude in the position of distal end portion 61 of suction nozzle 6 is measured by laser displacement meter 200, the configuration is not limited thereto. In another embodiment, an amplitude in the position of distal end portion 61 of suction nozzle 6 may be measured by a linear encoder. The linear encoder includes a scale head and a linear scale (a mover). The linear scale can indicate the position of distal end portion 61 of suction nozzle 6. An amplitude in the position of distal end portion 61 of suction nozzle 6 is measured by the scale head acquiring positional information of the linear scale. The linear encoder can measure an amplitude in accordance with a frequency component in the vibration of suction nozzle 6 by through fast Fourier transform of the positional information of the linear scale. An amplitude in the position of distal end portion 61 of suction nozzle 6 may be measured by a rotary encoder in place of the linear encoder. As in the case with the linear encoder, the rotary encoder includes a scale head and a linear scale (a moving member)Like linear encoders, rotary encoders have a scale head and a linear scale (a mover).

In the embodiment described above, while steps S21 to S23 in the second process are executed, these steps can also be omitted.

In the above embodiment, the work machine was a component mounting device 1 but is not limited to this configuration, and the work machine may be, for example, another machine tool.

In the embodiment described above, while dynamic vibration absorber 50 is made up of the cylindrical weight, the configuration is not limited thereto. In another embodiment, as shown in Fig. 8, dynamic vibration absorber 50 may be a bell-shaped damper. Dampers 50 of multiple types exist (one damper 50 is shown in Fig. 8) as dynamic vibration absorbers 50 of multiple types. For example, there are four types of dampers 50 of 100g, 200g, 300g, and 400g. Each damper 50 is configured to be attached to corresponding attachment portion 60 with, for example, screws or the like. Each damper 50 includes an outer portion 51 and an inner portion 52. Outer portion 51 covers inner portion 52. Outer portion 51 is formed of a spherical member. Outer portion 51 is formed hollow. Inner portion 52 is formed of a spherical member. Inner portion 52 is formed solid. Inner portion 52 is disposed in an interior of outer portion 51. Inner portion 52 is allowed to move freely in the interior of outer portion 51. Cavity 55 is formed between an inner surface of outer portion 51 and an outer surface of inner portion 52. Each damper 50 has a predetermined weight.

While a specific example of the present invention has been described in detail above, this is merely illustrative and does not limit the scope of the claims. -A The techniques illustrated in the present description or the drawings can achieve multiple objects simultaneously and provide technical usefulness by achieving one object in the multiple objects.

### Reference Signs List

1: component mounting device, 2: circuit board, 4: electronic component, 6: suction nozzle, 10: operation section, 12: component feeder, 14: feeder holding section, 16: mounting head, 18: moving mechanism, 18a: movement base, 20: imaging unit, 21: surface, 22: camera support, 24: camera, 26: conveyance device, 28: operation panel, 29: liquid crystal display section, 30: control section, 31: memory, 32: support device, 34: support pin, 38: support table, 41: device table, 42: support section, 43: hood, 50: dynamic vibration absorber, 60: attachment portion, 61: distal end portion, 62: tip, 100: floor, 200: laser displacement meter

## Claims

1. A method for using a work machine (1) comprising an operation section (10), a display section (29), and a memory section (31), comprising:
a step of determining positional information indicating an attachment position (601, 602, 603, 604) and/or type information indicating a type (501, 502, 503, 504) of at least one dynamic vibration absorber (50) for which an amplitude in a specific position on the work machine (1) becomes equal to or smaller than a predetermined threshold amplitude when the work machine (1) vibrates as a result of the operation section (10) operating with the at least one dynamic vibration absorber (50) attached to the work machine (1),
a step of storing the positional information and/or type information of the at least one dynamic vibration absorber (50) in the memory section (31);
a step of installing the work machine in a place different from the place where the former steps have been executed, and
a subsequent step of displaying the positional information and/or the type information of the at least one dynamic absorber (50), which is caused to be stored in the memory section (31), on the display section (29).

2. The method for using a work machine (1) according to claim 1,
wherein the predetermined threshold amplitude is determined based on an amplitude in the specific position on the work machine (1), the amplitude of which being obtained when the work machine (1) vibrates as a result of the operation section (10) operating without the dynamic vibration absorber (50) attached to the work machine (1).

3. The method for using a work machine (1) according to any one of claims 1 to 2,
wherein the work machine (1) is a component mounting device (1) for mounting a component (4) on a board (2).

4. The method for using a work machine (1) according to claim 3,
wherein the component mounting device (1) comprises a nozzle (6) configured to move upwards and downwards with respect to the board (2), and
wherein the specific position is a position of a distal end portion (61) of the nozzle (6).

5. The method for using a work machine (1) according to any one of claims 1 to 4,
wherein an amplitude in the specific position is an amplitude measured by a laser displacement meter (200) configured to irradiate laser to the specific position.

6. The method for using a work machine (1) according to any one of claims 1 to 4,
wherein an amplitude in the specific position is an amplitude measured by an encoder comprising a mover configured to indicate the specific position.

## Patentansprüche

1. Verfahren zur Verwendung einer Arbeitsmaschine (1), die einen Bedienabschnitt (10), einen Anzeigeabschnitt (29) und einen Speicherabschnitt (31) umfasst, umfassend:
einen Schritt des Bestimmens von Positionsinformationen, die eine Befestigungsposition (601, 602, 603, 604) angeben, und/oder Typinformationen, die einen Typ (501, 502, 503, 504) von mindestens einem dynamischen Schwingungsdämpfer (50) angeben, für den eine Amplitude in einer spezifischen Position an der Arbeitsmaschine (1) gleich oder kleiner als eine vorbestimmte Schwellenamplitude wird, wenn die Arbeitsmaschine (1) infolge des Betriebs des Betriebsabschnitts (10) vibriert während der mindestens eine dynamische Schwingungsdämpfer (50) an der Arbeitsmaschine (1) befestigt ist,
einen Schritt des Speicherns der Positionsinformationen und/oder Typinformationen des mindestens einen dynamischen Schwingungsdämpfers (50) im Speicherabschnitt (31),
einen Schritt des Installierens der Arbeitsmaschine (1) an einem anderen Ort als dem Ort, an dem die vorherigen Schritte ausgeführt wurden; und
einen anschließenden Schritt des Anzeigens der Positionsinformationen und/oder der Typinformationen des mindestens einen dynamischen Schwingungsdämpfers (50), die im Speicherabschnitt (31) gespeichert wurden, auf dem Anzeigeabschnitt (29).

2. Verfahren zur Verwendung einer Arbeitsmaschine (1) nach Anspruch 1,
wobei die vorbestimmte Schwellenamplitude auf der Grundlage einer Amplitude in der spezifischen Position an der Arbeitsmaschine (1) bestimmt wird, wobei deren Amplitude erhalten wird, wenn die Arbeitsmaschine (1) infolge des Betriebs des Betriebsabschnitts (10) vibriert ohne dass der dynamische Schwingungsdämpfer (50) an der Arbeitsmaschine (1) befestigt ist.

3. Verfahren zur Verwendung einer Arbeitsmaschine (1) nach einem der Ansprüche 1 bis 2,
wobei es sich bei der Arbeitsmaschine (1) um eine Bauteilmontagevorrichtung (1) zur Montage eines Bauteils (4) auf einer Platine (2) handelt.

4. Verfahren zur Verwendung einer Arbeitsmaschine (1) nach Anspruch 3,
wobei die Bauteilmontagevorrichtung (1) eine Düse (6) umfasst, die so konfiguriert ist, dass sie sich in Bezug auf die Platine (2) nach oben und unten bewegt, und
wobei die spezifische Position eine Position eines distalen Endabschnitts (61) der Düse (6) ist.

5. Verfahren zur Verwendung einer Arbeitsmaschine (1) nach einem der Ansprüche 1 bis 4,
wobei eine Amplitude in der spezifischen Position eine Amplitude ist, die von einem Laserverschiebungsmesser (200) gemessen wird, der konfiguriert ist, um den Laser auf die spezifische Position zu strahlen.

6. Verfahren zur Verwendung einer Arbeitsmaschine (1) nach einem der Ansprüche 1 bis 4,
wobei eine Amplitude in der spezifischen Position eine Amplitude ist, die von einem Encoder gemessen wird, der einen Beweger umfasst, der konfiguriert ist, um die spezifische Position anzuzeigen.

## Revendications

1. Procédé d'utilisation d'une machine de travail (1) comprenant une section d'opération (10), une section d'affichage (29) et une section de mémoire (31), comprenant :
une étape de détermination d'information de position indiquant une position d'attachement (601, 602, 603, 604) et/ou de l'information de type indiquant un type (501, 502, 503, 504) d'au moins un amortisseur de vibration dynamique (50) pour lequel une amplitude dans une position spécifique sur la machine de travail (1) devient inférieure ou égale à une amplitude seuil prédéterminée quand la machine de travail (1) vibre suite au fonctionnement de la section d'opération (10) fonctionnant avec ledit au moins un amortisseur de vibration dynamique (50) attaché à la machine de travail (1),
une étape de stockage de l'information de position et/ou de l'information de type dudit au moins un amortisseur de vibration dynamique (50) dans la section de mémoire (31) ;
une étape d'installation de la machine de travail dans un endroit différent de l'endroit où les étapes précédentes ont été exécutées, et
une étape suivante d'affichage de l'information de position et/ou de l'information de type dudit au moins un amortisseur dynamique (50), qui est stocké dans la section de mémoire (31), sur la section d'affichage (29).

2. Procédé d'utilisation d'une machine de travail (1) selon la revendication 1,
dans lequel l'amplitude seuil prédéterminée est déterminée sur la base d'une amplitude dans la position spécifique sur la machine de travail (1), son amplitude étant obtenue quand la machine de travail (1) vibre suite au fonctionnement de la section d'opération (10) sans l'amortisseur de vibration dynamique (50) attaché à la machine de travail (1).

3. Procédé d'utilisation d'une machine de travail (1) selon l'une quelconque des revendications 1 et 2,
dans lequel la machine de travail (1) est un dispositif de montage de composants (1) destinée à monter un composant (4) sur une carte (2).

4. Procédé d'utilisation d'une machine de travail (1) selon la revendication 3,
dans lequel le dispositif de montage de composants (1) comprend une buse (6) configurée pour se déplacer vers le haut et vers le bas par rapport à la carte (2), et
dans lequel la position spécifique est une position d'une portion d'extrémité distale (61) de la buse (6).

5. Procédé d'utilisation d'une machine de travail (1) selon l'une quelconque des revendications 1 à 4,
dans lequel une amplitude dans la position spécifique est une amplitude mesurée par un capteur de déplacement laser (200) configuré pour irradier le laser vers la position spécifique.

6. Procédé d'utilisation d'une machine de travail (1) selon l'une quelconque des revendications 1 à 4,
dans lequel une amplitude dans la position spécifique est une amplitude mesurée par un codeur comprenant un moteur configuré pour indiquer la position spécifique.
